# EUROPÄISCHE PATENTSCHRIFT

(11) **EP 1 294 096 B1**
(45) Veröffentlichungstag und Bekanntmachung des Hinweises auf die Patenterteilung: **14.11.2012**
(21) Anmeldenummer: 02020045.7
(22) Anmeldetag: 06.09.2002
(51) Int. Cl.: H03K 17/969, H03K 17/96, G06F 3/033

(54) **Optoelektronische Tastatur sowie Verfahren zur Steuerung einer optoelektronischen Tastatur**
Optoelectronic keyboard and method for controlling it
Clavier opto-électronique et procédé de commande du même

(30) Priorität: 13.09.2001 DE 10145248
(43) Veröffentlichungstag der Anmeldung: 19.03.2003
(73) Patentinhaber: KROHNE MESSTECHNIK GMBH & CO. KG, 47058 Duisburg (DE)
(72) Erfinder: Wolter, Jürgen, Dipl.-Ing., 46145 Oberhausen (DE); Stelz, Wolfgang, Dipl.-Ing., 46047 Oberhausen (DE); Ludwig, Detlef, 47228 Duisburg (DE)
(74) Vertreter: Gesthuysen, von Rohr & Eggert

(56) Entgegenhaltungen:
- EP-A- 0 458 513
- DE-A- 19 654 853
- DE-C- 4 041 144
- DE-C- 4 336 669
- US-A- 4 701 747

## Beschreibung

Die Erfindung betrifft ein Verfahren zur Datenübertragung mittels einer optoelektronischen Tastatur eines Meßgerätes, wobei die optoelektronische Tastatur eine lichtdurchlässige Tastplatte, wenigstens zwei Tastflächen, wenigstens zwei Lichtsender und wenigstens zwei Lichtempfänger aufweist, die Tastflächen auf der einen Seite der Tastplatte auf deren Oberfläche vorgesehen sowie einander benachbart sind, die Lichtsender und die Lichtempfänger auf der anderen Seite der Tastplatte vorgesehen sowie ebenfalls einander benachbart sind, jeweils eine Tastfläche, ein Lichtsender und ein Lichtempfänger einander zugeordnet sind, so daß sie funktional eine Taste bilden, indem bei betätigter Tastfläche einer Taste von dem Lichtsender dieser Taste ausgesandtes Licht an der betätigten Tastfläche reflektiert wird und auf den Lichtempfänger dieser Taste fällt. Daß, wie zuvor gesagt, das von dem Lichtsender der Taste ausgesandte Licht an der betätigten Taste reflektiert wird bedeutet in diesem Zusammenhang, daß das Licht z. B. an einem Finger reflektiert wird, der in die Nähe der Taste gebracht bzw. auf die Tastfläche aufgelegt wird.

Eine solche optoelektronische Tastatur ist z. B. aus der EP 0 618 680 A1 bekannt. Dort ist eine optoelektronische Tastatur beschrieben, die Infrarot-Lichtsender und Infrarot-Lichtempfänger aufweist, wobei einander zugeordnete Infrarot-Lichtsender und Infrarot-Lichtempfänger derart relativ zueinander angeordnet sind, daß bei betätigter Tastfläche, also wenn z. B. ein Finger auf der Tastfläche aufliegt oder sich in deren Nähe befindet, von dem Infrarot-Lichtsender ausgestrahltes Licht derart zurückreflektiert wird, daß es im wesentlichen ausschließlich von dem dem Infrarot-Lichtsender zugeordneten Infrarot-Lichtempfänger empfangen wird. Neben einer entsprechenden Ausrichtung der Infrarot-Lichtsender und Infrarot-Lichtempfänger zueinander sind dazu Infrarotlicht reflektierende bzw. Infrarotlicht nichtreflektierende Abdeckungen vorgesehen. Auf diese Weise soll vermieden werden, daß bei Betätigung einer Taste durch Berühren der entsprechenden Tastfläche mit einem Finger, die von dem Finger ausgehenden Reflektionen auch von anderen Infrarot-Lichtempfängern detektiert werden, als von dem Infrarot-Lichtempfänger, der dem Infrarot-Lichtsender zugeordnet ist, von dem das am Finger zurückreflektierte Licht ausgesandt worden ist. Wird nämlich das zurückreflektierte Licht von mehr als einem Infrarot-Lichtempfänger detektiert, so kann nicht mehr eindeutig festgestellt werden, welche Taste tatsächlich betätigt worden ist, bzw. es ist nicht klar, ob nur eine Taste oder zwei Tasten gleichzeitig betätigt worden sind.

Bei der aus der EP 0 618 680 A1 bekannten optoelektronischen Tastatur ist somit der minimal mögliche Abstand zweier Tasten zueinander dadurch begrenzt, daß durch Reflektionen an einem auf der Tastfläche einer Taste aufliegende Finger Licht vom Infrarot-Lichtsender dieser Taste nicht zu dem Infrarot-Lichtempfänger der dieser Taste benachbarten Taste gelangen darf. Darüber hinaus ist der minimal mögliche Abstand zweier einander benachbarter Tasten zueinander dadurch begrenzt, daß bei guten Reflektionsbedingungen eine nur teilweise betätigte Taste, z. B. im Falle eines nicht ausschließlich auf der Tastfläche lediglich einer Taste aufliegenden Fingers, die Betätigung mehrerer Tasten angenommen wird.

Weitere Probleme bei bekannten optoelektronischen Tastaturen liegen darin, daß bei intensivem Lichteinfall, wie bei starker Sonneneinstrahlung, die Betätigung einer Taste nicht sicher erkannt werden kann, da die intensiv bestrahlten Lichtempfänger bereits übersteuert sind. Andererseits ist die Detektion der Betätigung einer Taste bei schlechten Reflektionsbedingungen, wie z. B. bei der Betätigung einer Taste mit einem von einem schwarzen Handschuh bedeckten Finger, schwierig. Schließlich ist die Forderung, daß das Licht im wesentlichen als Reflektion von einem die Taste betätigenden Finger und nicht von der Tastplatte, insbesondere nämlich nicht von deren Außenseite, empfangen wird, in der Praxis schwer zu erfüllen, da dazu der Abstand des Lichtsenders sowie des Lichtempfängers von der Tastplatte sehr genau eingehalten werden muß. Insbesondere aufgrund von Mahrfachreflektionen führen schon geringe Abweichungen von den erforderlichen Abständen zu Fehldetektionen.

Die DE 196 54 853 A1 beschreibt eine optoelektronische Tastatur mit einer Taste, die eine Leuchtelektrode aufweist, die einerseits, abwechselnd als Lichtsender bzw. Lichtempfänger wirkend, zur bidirektionalen Datenkommunikation dient und andererseits in einem Multiplex-Betrieb als Betätigungssensor der optoelektronischen Tastatur verwendet wird.

Die US 4,701,747 offenbart ein Dateneingabesystem, mit einem Tastenfeld aus chemisch versteiftem Schichtglas, wobei auf der Oberseite der Frontplatte eine Vielzahl von Tastenflächen vorgesehen sind, und benachbart zur Unterseite der Frontplatte eine Vielzahl von LEDs angeordnet sind und wobei jeder LED einer Fotodiode zugeordnet ist, die von der zugeordneten LED ausgesandtes, durch die Glasfrontplatte übertragenes, von dem Finger eines Benutzers reflektiertes Infrarotlicht empfängt, wenn der Finger zur Betätigung der Taste auf die entsprechende Tastenfläche gelegt wurde. Dabei ist einer Fotodiode auch ein Verstärker nachgeordnet.

Aufgabe der Erfindung ist es, ein verbessertes Verfahren zur Datenübertragung mittels einer optoelektronischen Tastatur eines Messgeräts anzugeben.

Die zuvor aufgezeigte Aufgabe ist ausgehend von dem eingangs beschriebenen Verfahren gelöst, indem eine zentrale Steuer- und Auswerteschaltung und ein Komparator vorgesehen sind, wenigstens einer der Lichtsender und wenigstens einer der Lichtempfänger mit der zentralen Steuer- und Auswerteschaltung verbunden sind, dem mit der zentralen Steuer- und Auswerteschaltung verbundenen Lichtempfänger ein Verstärker nachgeschaltet ist, der mit der zentralen Steuer- und Auswerteschaltung verbundene Lichtsender und der mit der zentralen Steuer- und Auswerteschaltung verbundene Lichtempfänger derart von der zentralen Steuer- und Auswerteschaltung angesteuert werden, daß über den mit der zentrale Steuer- und Auswerteschaltung verbundenen Lichtsender ausgesandte Daten und von dem mit der zentralen Steuer- und Auswerteschaltung verbundenen Lichtempfänger empfangene Daten zur Kommunikation mit einem externen Gerät nutzbar sind und der Verstärker von der zentralen Steuer- und Auswerteschaltung derart angesteuert wird, daß während einer Datenübertragung von dem externen Gerät die Verstärkungsleistung des Verstärkers reduziert wird, wobei die mit dem Lichtempfänger empfangenen Daten dem Komparator zugeführt werden, der die in den Daten enthaltenen Informationen auswertet und an die zentrale Steuer- und Auswerteschaltung weiterleitet.

Gemäß einer bevorzugten Weiterbildung der Erfindung ist vorgesehen, daß die zentrale Steuer- und Auswerteschaltung von einem Mikro-Controller gebildet wird. Dabei kann in dem Mikro-Controller ein Analog/Digital-Wand/er mit einer der Anzahl der Tasten der optoelektronischen Tastatur entsprechenden Anzahl von Eingängen vorgesehen sein. Eine entsprechende Integration des Analog/Digital-Wandlers in den Mikro-Controller ist nicht zwingend erforderlich, erleichtert jedoch den Aufbau einer kompakten optoelektronischen Tastatur. Schließlich ist gemäß einer bevorzugten Weiterbildung der Erfindung vorgesehen, daß zwischen einen jeden Eingang des im Mikro-Controller vorgesehenen Analog/Digital-Wandlers und einem jeden Lichtempfänger jeweils ein Verstärker angeordnet ist, der das von dem Lichtempfänger ausgegebene Signal verstärkt.

Eine bevorzugte Weiterbildung der optoelektronischen Tastatur liegt nunmehr auch darin, daß eine Kommunikationseinrichtung vorgesehen ist, wenigstens ein Lichtsender und/oder wenigstens ein Lichtempfänger mit der Kommunikatiönsrichtung verbunden ist und der Lichtsender und/oder Lichtempfänger derart von der Kommunikationseinrichtung ansteuerbar sind, daß über den Lichtsender ausgesandte Daten bzw. von dem Lichtempfänger empfangene Daten zur Kommunikation mit einem externen Gerät nutzbar sind. Diese Weiterbildung ist sowohl auf die zuvor beschriebene erfindungsgemäße optoelektronische Tastatur als auch auf herkömmliche optoelektronische Tastaturen anwendbar. Eine entsprechend ausgebildete optoelektronische Tastatur ist insofern vorteilhaft, als daß eine drahtlose Datenübertragung zwischen dem externen Gerät und dem Meßgerät ohne zusätzliche Einrichtungen ermöglicht wird. Das heißt, daß keine eigene Sender-/Empfängereinrichtung für diese drahtlose Kommunikation erforderlich ist, da die schon vorhandenen mit jeweils einem Lichtsender und einem Lichtempfänger ausgestatteten Tasten der optoelektronischen Tastatur verwendet werden. Die Zusatzkosten für die Ausstattung eines Meßgeräts für diese Art der Datenübertragung sind damit sehr gering. Dabei gilt natürlich, daß während dieser Art der Kommunikation mit dem externen Gerät eine Verwendung der optoelektronischen Tastatur im herkömmlichen Sinne nicht möglich ist.

Erfindungsgemäß ist vorgesehen, daß der Lichtsender zusammen mit dem ihm zugeordneten Lichtempfänger zur Kommunikation mit dem externen Gerät nutzbar ist. Das heißt, daß genau eine Taste mit ihrem Lichtsender und ihrem Lichtempfänger für die Kommunikation mit dem externen Gerät verantwortlich ist, was die erforderliche Ausrichtung des externen Geräts mit seinem Anschluß für diese Art der Kommunikation auf die optoelektronische Tastatur erleichtert.

Eine weitere Erleichterung der richtigen Ausrichtung des externen Geräts auf die optoelektronische Tastatur wird gemäß einer bevorzugten Weiterbildung der Erfindung dadurch erreicht, daß der Lichtsender zusammen mit einer Mehrzahl von Lichtempfängern, vorzugsweise zusammen mit allen Lichtempfängern, zur Kommunikation mit dem externen Gerät nutzbar ist. Insbesondere können auch dabei alle Lichtempfänger "gleichzeitig" verwendet werden, mehrere Lichtempfänger können also sozusagen jederzeit "in Bereitschaft" stehen, was die Aufnahme der Kommunikation mit dem externen Gerät erleichtert.

Darüber hinaus ist erfindungsgemäß vorgesehen, daß die Verstärkung des Lichtempfängers einstellbar ist, so daß im Falle der Datenübertragung die Verstärkung reduzierbar ist. Hierdurch wird die Bandbreite der Datenübertragung vergrößert und die Übertragungsgeschwindigkeit erhöht. Maximale Datenübertragungsgeschwindigkeiten bis zu 115 Kbaud sind damit bisher erreichbar. Insbesondere ist eine Anpassung dieser Art der Datenübertragung wenigstens teilweise an den IrDA-Standard möglich, d.h. es können eine serielle asynchrone Übertragung, eine Bidirektionalübertragung und eine Übertragung von H-Pegeln durch kurze Pulse (3/16-Länge eines Bits) vorgesehen sein. Die Aktivierung der Datenübertragung wird durch einen Anmeldevorgang initiiert. Dieser kann entweder durch besondere Pulsfolgen, die von dem externen Gerät gesendet und von dem Meßgerät im normalen Tastenbetrieb erkannt werden, oder aber durch zyklische Versuche des Meßgeräts, eine Datenübertragung aufzubauen, erfolgen.

Sonstige bevorzugte Weiterbildungen des erfindungsgemäßen Verfahrens zur Steuerung einer optoelektronischen Tastatur ergeben sich in Analogie zu den zuvor beschriebenen bevorzugten Weiterbildungen der erfindungsgemäßen optoelektronischen Tastatur.

Im einzelnen gibt es nun eine Vielzahl von Möglichkeiten, das erfindungsgemäße Verfahren zur Steuerung der optoelektronischen Tastatur auszugestalten und weiterzubilden. Dazu wird auf die dem unabhängigen Patentanspruch nachgeordneten Patentansprüche sowie auf die nachfolgende Beschreibung bevorzugter Ausführungsbeispiele der Erfindung unter Bezugnahme auf die Zeichnung verwiesen. In der Zeichnung zeigt
- Fig. 1: im Schnitt schematisch einen Ausschnitt einer optoelektronischen Tastatur gemäß einem bevorzugten Ausführungsbeispiel der Erfindung mit durch einen Finger betätigter Taste,
- Fig. 2: schematisch den Aufbau einer optoelektronischen Tastatur gemäß einem bevorzugten Ausführungsbeispiel der Erfindung und
- Fig. 3: schematisch den Aufbau einer optoelektronischen Tastatur gemäß einem anderen bevorzugten Ausführungsbeispiel der Erfindung.

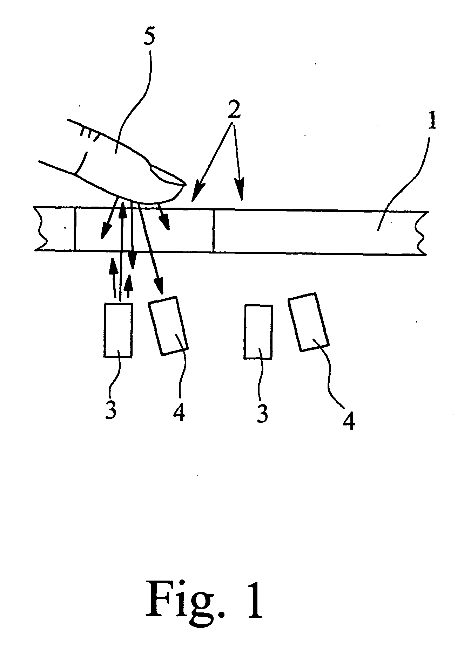

Aus Fig. 1 ist schematisch ein Bereich einer optoelektronischen Tastatur für ein Meßgerät gemäß einem bevorzugten Ausführungsbeispiel der Erfindung im Schnitt ersichtlich. Die optoelektronische Tastatur umfaßt eine lichtdurchlässige Tastplatte 1, die auf ihrer nach oben gerichteten Seite zwei Tastflächen 2 aufweist. Unterhalb einer jeden Tastfläche 2 der Tastplatte 1 befinden sich jeweils ein Lichtsender 3 und ein Lichtempfänger 4. Der Lichtsender 3 sendet Licht, vorliegend Infrarotlicht, nach oben und dabei im wesentlichen senkrecht zur Ebene der Tastplatte 1 aus. Wird nun eine Taste betätigt, indem ein Finger 5 auf die Tastfläche 2 der Tastplatte 1 gebracht wird, so kommt es zu Reflektionen des von dem Lichtsender 3 ausgesandten Lichts an dem Finger 5, und das reflektierte Licht fällt wenigstens teilweise auf den Lichtempfänger 4 zurück, so daß über das von dem Lichtempfänger 4 detektierte Lichtsignal eine Betätigung der entsprechenden Taste erfaßt werden kann.

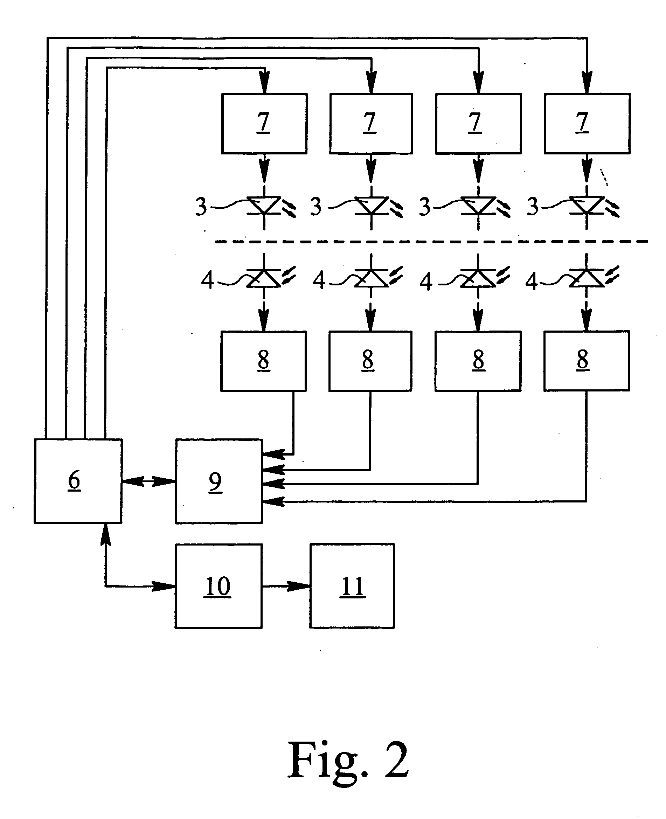

Der schematische Aufbau einer optoelektronischen Tastatur gemäß einem bevorzugten Ausführungsbeispiel der Erfindung ist nun aus Fig. 2 ersichtlich. Wesentlich ist dabei, daß eine zentrale Steuer- und Auswerteschaltung 6 vorgesehen ist, die mit allen Lichtsendern 3 sowie mit allen Lichtempfangern 4 verbunden ist. Vorliegend sind jeweils vier Lichtsender 3 sowie vier, einem jeweiligen Lichtsender 3 zugeordnete Lichtempfänger 4 dargestellt, die längs einer Reihe angeordnet sind. Die mittleren beiden Lichtsender 3 bzw. Lichtempfänger 4 haben somit jeweils zwei benachbarte Lichtsender 3 bzw. Lichtempfänger 4, während die äußeren Lichtsender 3 bzw. Lichtempfänger 4 nur jeweils einen benachbarten Lichtsender 3 bzw. Lichtempfänger 4 aufweisen.

Die zentrale Steuer- und Auswerteschaltung 6 ist mit den Lichtsendern 3 jeweils über einen Schalter 7 verbunden. Über den Schalter 7 ist die jeweilige Ansteuerung eines Lichtsenders 3 von der zentralen Steuer- und Auswerteschaltung 6 möglich. Die Schalter 7 werden dabei zeitlich nacheinander von der zentralen Steuer- und Auswerteschaltung 6 aktiviert, so daß jeweils nur ein einziger Lichtsender 3 aktiv ist, also Licht aussendet.

Den Lichtempfängern 4 ist jeweils ein Verstärker 8 nachgeschaltet, der das von den Lichtempfängern 4 ausgegebene Signal verstärkt. Dieses verstärkte Signal wird dann auf einen Analog-Digital-Wandler 9 gegeben, der eine der Anzahl der Lichtempfänger 4 entsprechende Anzahl von Eingängen aufweist. In diesem Analog/Digital-Wandler 9 werden die von den Lichtempfängern 4 ausgegebenen analogen Signale digitalisiert und dann auf die zentrale Steuer- und Auswerteschaltung 6 gegeben. Diese ist gemäß dem vorliegend beschriebenen bevorzugten Ausführungsbeispiel der Erfindung als Mikro-Controller ausgebildet.

Die Funktionsweise der aus Fig. 2 ersichtlichen optoelektronischen Tastatur gemäß einem bevorzugten Ausführungsbeispiel der Erfindung ist nun derart, daß in Abhängigkeit von den über die Schalter 7 zeitlich nacheinander aktivierten Lichtsendern 3 von der zentralen Steuer- und Auswerteschaltung 6 nur das von einem jeweils dem aktivierten Lichtsender 3 zugeordneten Lichtempfänger 4 kommende Signal ausgewertet wird. Auf diese Weise wird sichergestellt, daß bei für einen Lichtempfänger 4 detektiertem Signal tatsächlich eine Betätigung der entsprechenden Taste vorliegt, also das Signal von einer Reflektion von dem zugeordneten Lichtsender 3 ausgesandten Licht herrührt. Die Fehldetektion einer betätigten Taste durch Reflektionen von Licht auf einen "falschen" Lichtempfänger 4 ist somit praktisch ausgeschlossen.

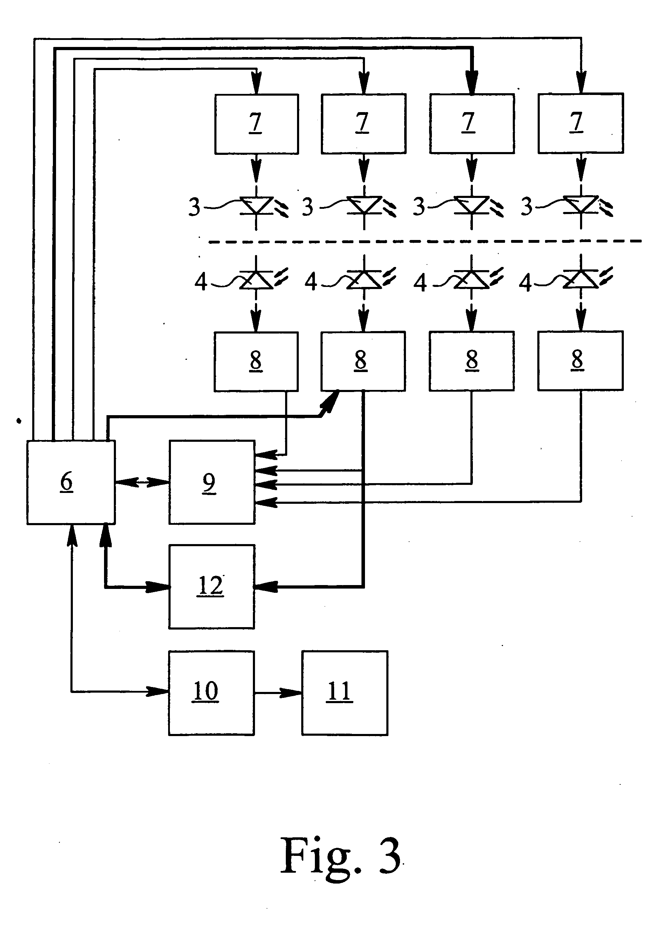

Mit der zentralen Steuer- und Auswerteschaltung 6 ist über eine Anzeigesteuereinrichtung 10 eine Anzeige 11 für die über die optoelektronische Tastatur ausgewählten Funktionen verbunden. Auf diese Weise wird dem Verwender des mit der optoelektronischen Tastatur ausgerüsteten Meßgeräts unmittelbar nach Betätigung einer Taste mitgeteilt, welche Funktion er damit ausgewählt hat, wodurch ein Überprüfungs- und Sicherheitsmechanismus eingeführt wird. Aus Fig. 3 ist nun eine optoelektronische Tastatur gemäß einem anderen bevorzugten Ausführungsbeispiel der Erfindung ersichtlich. Der Aufbau der aus Fig. 3 ersichtlichen optoelektronischen Tastatur gemäß einem anderen bevorzugten Ausführungsbeispiel der Erfindung entspricht im wesentlichen dem Aufbau der zuvor beschriebenen optoelektronischen Tastatur bis auf die Tatsache, daß zusätzlich ein Komparator 12 vorgesehen und, wie mit einem Pfeil angedeutet, eine Steuerung eines mit dem Komparator 12 verbundenen Verstärkers 8 bezüglich seiner Verstärkungsleistung durch die zentrale Steuer- und Auswerteschaltung 6 vorgesehen ist.

Gemäß dem aus Fig. 3 ersichtlichen bevorzugten Ausführungsbeispiel der Erfindung werden außerdem ein Lichtsender 3 und eine Lichtempfänger 4 für die Kommunikation mit einem externen Gerät verwendet. Dazu wird, wie mit einem dicken Pfeil gekennzeichnet, der zweite Lichtsender 3 von rechts sowie der zweite Lichtempfänger 4 von links über den zugeordneten Schalter 7 bzw. den zugeordneten Verstärker 8 von der zentralen Steuer- und Auswerteschaltung 6 angesteuert. Der für die Kommunikation mit dem externen Gerät vorgesehene Lichtsender 3 wird nämlich über den ihm zugeordneten Schalter 7 so angesteuert, daß die von ihm erzeugten Lichtdaten, einem vorbestimmten Format und Protokoll folgend, von dem externen Gerät empfangen und verstanden werden können. Von dem externen Gerät ausgesandte Lichtdaten werden von dem genannten Lichtempfänger 4 empfangen und dem Komparator 12 zugeführt, der die in den Lichtdaten enthaltenen Informationen auswertet und an die zentrale Steuer- und Auswerteschaltung 6 weiterleitet.

Die Verstärkung des dem für den Empfang von dem externen Gerät ausgesandten Lichtdaten vorgesehenen Lichtempfänger 4 zugeordneten Verstärker 8 ist von der zentralen Steuer- und Auswerteschaltung 6 steuerbar und wird im Falle einer Datenübertragung von dem externen Gerät reduziert. Eine reduzierte Verstärkung des Verstärkers 8 führt nämlich zu einer Vergrößerung der erzielbaren Bandbreite sowie zu einer Erhöhung der möglichen Übertragungsgeschwindigkeit. Auf diese Weise sind gegenwärtig maximale Datenübertragungsgeschwindigkeiten von bis zu 115 Kbaud möglich.

Die Datenübertragung zwischen dem externen Gerät und der optoelektronischen Tastatur gemäß dem vorliegenden bevorzugten Ausführungsbeispiel der Erfindung wird durch einen Anmeldevorgang aktiviert. Dabei kann einerseits vorgesehen sein, daß der Anmeldevorgang durch besondere Pulsfolgen initiiert wird, die von dem externen Gerät gesendet und von der optoelektronischen Tastatur im normalen Tastaturbetrieb erkannt werden. Andererseits ist es möglich, den Anmeldevorgang durch zyklische Versuche der optoelektronischen Tastatur zu initiieren, eine Datenübertragung mit einem externen Gerät herzustellen. Die Übertragungscharakteristik gemäß dem vorliegend beschriebenen bevorzugten Ausführungsbeispiel der Erfindung ist teilweise an den IrDA-Standard angepaßt. Es sind eine serielle asynchrone Übertragung, eine Bidirektionalübertragung sowie eine Übertragung von H-Pegeln durch kurze Pulse (3/16-Länge eines Bits) möglich. Erfolgt schließlich keine Datenübertragung zwischen der optoelektronischen Tastatur und dem externen Gerät mehr, so kann die optoelektronische Tastatur wieder für ihren normalen Tastaturbetrieb eingesetzt werden.

## Patentansprüche

1. Verfahren zur Datenübertragung mittels einer optoelektronischen Tastatur eines Meßgerätes, wobei die optoelektronische Tastatur eine lichtdurchlässige Tastplatte (1), wenigstens zwei Tastflächen (2), wenigstens zwei Lichtsender (3) und wenigstens zwei Lichtempfänger (4) aufweist, die Tastflächen (2) auf der einen Seite der Tastplatte (1) auf deren Oberfläche vorgesehen sowie einander benachbart sind, die Lichtsender (3) und die Lichtempfänger (4) auf der anderen Seite der Tastplatte (1) vorgesehen sowie ebenfalls einander benachbart sind, jeweils eine Tastfläche (2), ein Lichtsender (3) und ein Lichtempfänger (4) einander zugeordnet sind, so daß sie funktional eine Taste bilden, indem bei betätigter Tastfläche (2) einer Taste von dem Lichtsender (3) dieser Taste ausgesandtes Licht an der betätigten Tastfläche (2) reflektiert wird und auf den Lichtempfänger (4) dieser Taste fällt, **dadurch gekennzeichnet, dass** eine zentrale Steuer- und Auswerteschaltung (6) und ein Komparator (12) vorgesehen sind, wenigstens einer der Lichtsender (3) und wenigstens einer der Lichtempfänger (4) mit der zentralen Steuer- und Auswerteschaltung (6) verbunden sind, dem mit der zentralen Steuer- und Auswerteschaltung (6) verbundenen Lichtempfänger (4) ein Verstärker (8) nachgeschaltet ist, der mit der zentralen Steuer- und Auswerteschaltung (6) verbundene Lichtsender (3) und der mit der zentralen Steuer- und Auswerteschaltung (6) verbundene Lichtempfänger (4) derart von der zentralen Steuer- und Auswerteschaltung (6) angesteuert werden, daß über den mit der zentralenSteuer- und Auswerteschaltung (6) verbundenen Lichtsender (3) ausgesandte Daten und von dem mit der zentralen Steuer- und Auswerteschaltung (6) verbundenen Lichtempfänger (4) empfangene Daten zur Kommunikation mit einem externen Gerät nutzbar sind und der Verstärker (8) von der zentralen Steuer- und Auswerteschaltung (6) derart angesteuert wird, daß während einer Datenübertragung von dem externen Gerät die Verstärkungsleistung des Verstärkers (8) reduziert wird, wobei die mit dem Lichtempfänger (4) empfangenen Daten dem Komparator (12) zugeführt werden, der die in den Daten enthaltenen Informationen auswertet und an die zentrale Steuer- und Auswerteschaltung (6) weiterleitet,

2. Verfahren nach Anspruch 1, **dadurch gekennzeichnet, daß** der Lichtsender (3) zusammen mit dem ihm zugeordneten Lichtempfänger (4) zur Kommunikation mit dem externen Gerät verwendet wird.

3. Verfahren nach Anspruch 1, **dadurch gekennzeichnet, daß** der Lichtsender (3) zusammen mit einer Mehrzahl von Lichtempfängern (4), zur Kommunikation mit dem externen Gerät verwendet wird.

4. Verfahren nach Anspruch 3, **dadurch gekennzeichnet, daß** alle Lichtempfänger (4) zur Kommunikation mit dem externen Gerät verwendet werden.

## Claims

1. Method for data transmission by means of an optoelectronic keypad, wherein the optoelectronic keypad comprises a transparent touch screen (1), at least two control buttons (2), at least two light emitters (3), at least two photo-detectors (4), said control buttons (2) being located next to each other on one side of the surface of the touch-screen (1), the light emitters (3) and the photo-detectors (4) being situated next to each other on the other side of the touch screen (1) and each one control button (2), light emitter (3) and photo-detector (4) being functionally associated with one another in a way as to constitute one action key, whereby pressing the control button (2) of an action key causes the light emanating from the light emitter (3) of that action key to be reflected at the actuated key (2) and to impinge on the photo-detector (4) of that key, **characterized in that** a central control and processing unit (6) and a comparator (12) are provided, at least one of the light emitter (3) and at least one of the photo detector (4) are joined to the central control and processing unit (6), an amplifier (8) being connected in series with the photo detector (4) joined to the central control and processing unit (6), the light emitter (3) joined to the central control and processing unit (6) and the photo-detector (4) joined to the central control and processing unit (6) being controlled by the central control and processing unit (6) in such a manner that data sent via the light emitter (3) joined to the central control and processing unit (6) and the data received by the photo detector (4) joined to the central control and processing unit (6) can be used for communication with an external device, and the amplifier (8) is controlled by the central control and processing unit (6) in such a manner that the gain control of the amplifier (8) is reduced during data transmission from an external device, wherein the data received by the photo-detector (4) are supplied to the comparator (12) which evaluates the information contained in the data and transfers it to the central control and processing unit (6).

2. Method according to claim 1, **characterized in that** the light emitter (3) is used together with its associated photo-detector (4) for communicating with the external device.

3. Method according to claim 1, **characterized in that** the light emitter (3) is used together with several photo-detectors (4) for communicating with the external device.

4. Method according to claim 3, **characterized in that** all photo-detectors (4) are used for communicating with the external device.

## Revendications

1. Procédé de transmission de données au moyen d'un clavier optoélectronique d'un instrument de mesure, dans lequel le clavier optoélectronique comporte une plaque à touches translucides (1), au moins deux surfaces de touches (2), au moins deux émetteurs de lumière (3) et au moins deux récepteurs de lumière (4), les surfaces de touches (2) étant prévues voisines sur la surface de la première face de la plaque à touches (1), les émetteurs de lumière (3) et les récepteurs de lumière (4) étant prévus également voisins sur l'autre face de la plaque à touches (1), une surface de touche (2), un émetteur de lumière (3) et un récepteur de lumière (4) étant respectivement attribués l'un à l'autre, de telle sorte que fonctionnellement, ils constituent ensemble une touche en ce que lorsqu'on actionne une surface de touche (2) d'une touche, la lumière émise par l'émetteur de lumière (3) de cette touche est réfléchie sur la surface de touche (2) actionnée et frappe le récepteur de lumière (4) de cette touche, **caractérisé en ce qu'**il est prévu un circuit central de commande et d'interprétation (6) et un comparateur (12), au moins un des émetteurs de lumière (3) et au moins un des récepteurs de lumière (4) étant reliés au circuit central de commande et d'interprétation (6), le récepteur de lumière (4) relié au circuit central de commande et d'interprétation (6) étant branché en aval d'un amplificateur (8), l'émetteur de lumière (3) relié au circuit central de commande et d'interprétation (6) et le récepteur de lumière (4) relié au circuit central de commande et d'interprétation (6) étant commandés par le circuit central de commande et d'interprétation (6) de manière à pouvoir utiliser les données émises par l'intermédiaire de l'émetteur de lumière (3) relié au circuit central de commande et d'interprétation (6) et les données reçues par l'intermédiaire du récepteur de lumière (4) relié au circuit central de commande et d'interprétation (6), pour la communication avec un appareil externe et l'amplificateur (8) du circuit central de commande et d'interprétation (6) est commandé de manière à réduire la puissance d'amplification de l'amplificateur (8) pendant une transmission de données à partir de l'appareil externe, les données reçues par le récepteur de lumière (4) étant acheminées vers le comparateur (12) qui traite les informations contenues dans les données et les transfère au circuit central de commande et d'interprétation (6).

2. Procédé selon la revendication 1, **caractérisé en ce que** l'émetteur de lumière (3) est utilisé de concert avec le récepteur de lumière (4) associé, pour la communication avec l'appareil externe.

3. Procédé selon la revendication 1, **caractérisé en ce que** l'émetteur de lumière (3) est utilisé de concert avec une pluralité de récepteurs de lumière (4) , pour la communication avec l'appareil externe.

4. Procédé selon la revendication 3, **caractérisé en ce que** tous les récepteurs de lumière (4) sont utilisés pour la communication avec l'appareil externe.
